# EUROPEAN PATENT SPECIFICATION

(11) **EP 0 619 378 B1**
(45) Date of publication and mention of the grant of the patent: **23.07.1997**
(21) Application number: 94105241.7
(22) Date of filing: 05.04.1994
(51) Int. Cl.: C22C 1/09, C22C 29/00

(54) **Method of preparing a diamond reinforced composite material**
Verfahren zur Herstellung eines diamantverstärktes Verbundmaterials
Méthode de préparation d'un matériau composite renforcé par du diamant

(30) Priority: 06.04.1993 JP 79611/93
(43) Date of publication of application: 12.10.1994
(60) Divisional application: 95114320.5
(73) Proprietor: SUMITOMO ELECTRIC INDUSTRIES, LIMITED, Osaka 541 (JP)
(72) Inventor: Yamamoto, Yoshiyuki, c/o Itami Works of, Itami-shi, Hyogo (JP); Imai, Takahiro, c/o Itami Works of, Itami-shi, Hyogo (JP); Tsuno, Takashi, c/o Itami Works of, Itami-shi, Hyogo (JP); Fujimori, Naoji, c/o Itami Works of, Itami-shi, Hyogo (JP)
(74) Representative: Herrmann-Trentepohl, Werner, Dipl.-Ing.

(56) References cited:
- EP-A- 0 493 351
- FR-A- 2 499 062
- US-A- 3 778 261
- US-A- 5 187 021
- POWDER METALLURGY INTERNATIONAL vol. 18, no. 2 , 1986 pages 76 - 78 Z. LIN AND R.A. QUEENEY 'Fracture Resistance of Diamond-Reinforced Hot Pressed Cu/Ni Powders'
- DATABASE WPI Week 8527, Derwent Publications Ltd., London, GB; AN 85-165066 & ZA-A-8 406 536 (DE BEERS IND DIAMOND) 21 February 1985

## Description

### BACKGROUND OF THE INVENTION

### Field of the Invention

The present invention relates to a diamond reinforced composite material for forming a component which must have lightweightness, high elasticity, high strength and high heat resistance in relation to an aircraft, an engine, an acoustic product or sports goods, and a method of preparing the same.

### Description of the Background Art

In general, a component which must have lightweightness, high elasticity, high strength or high heat resistance in relation to an aircraft, an engine, an acoustic product or sports goods is generally made of an aluminum alloy such as duralumin, or a fiber reinforced composite material such as a carbon fiber reinforced composite material. Well-known examples of the fiber reinforced composite material are carbon fiber reinforced resin (CFRP), a carbon fiber reinforced metal prepared by dispersing carbon fiber in a metal, and various ceramics fiber reinforced composite materials prepared by dispersing SiC fiber, glass fiber, SiC whisker, glass whisker and the like in metals or plastic materials. The fiber reinforced composite material having high strength is increasingly employed in recent years since the same is lighter than an aluminum alloy such as duralumin.

On the other hand, there have recently been proposed techniques of obtaining fibrous, needle-shaped or whiskery vapor-deposited diamond from a raw material of a mixed gas of hydrogen and hydrocarbon. For example, Japanese Patent Laying-Open No. 60-200896 (1985) discloses a technique of depositing fibrous diamond on a surface of a substrate containing transition metal particles of not more than 1000 Å in size adhering thereto from a raw material gas which is excited and decomposed under decompression. Japanese Patent Laying-Open No. 1-246116 (1989) discloses a technique of obtaining needle-shaped, fibrous or porous diamond by exposing a vapor-deposited diamond film to plasma containing oxygen, carbon dioxide, water steam, hydrogen, halogenated hydrocarbon or halogenated carbon, or heat treating the film in an air current containing oxygen, carbon dioxide or water steam. Japanese Patent Laying-Open No. 2-239192 (1990) discloses a technique of etching a vapor-deposited crude diamond film for converting the same to a needle-shaped diamond film and depositing pure diamond on the needle-shaped diamond film. Japanese Patent Laying-Open No. 1-246116 (1989) suggests such a potential that a diamond reinforced composite material having an excellent mechanical, thermal or chemical property such as high strength, high wear resistance, high heat conductivity or high corrosion resistance may be prepared by combining needle-shaped, fibrous or porous diamond with another matrix material.

In general, important technical subjects in relation to preparation of a fiber reinforced composite material are adhesion and bondability between materials to be combined with each other, i.e., a matrix and a reinforcing fiber material. Diamond has the maximum hardness and the maximum modulus of elasticity among materials. Since fibrous diamond is superior in hardness and modulus of elasticity to a reinforcing fiber material of carbon, SiC or glass, it is expected that a composite material which is reinforced with the fibrous diamond may attain higher strength than those reinforced with other fibrous materials. However, vapor-deposited diamond is inferior in adhesion and bondability with respect to another material such as a metal or plastic, and hence it is difficult to obtain a strongly bonded state by dispersing fibrous diamond in a matrix. Further, diamond is generally inferior in wettability with respect to another material such as a metal or plastic. Therefore, the range of raw materials for a matrix is restricted in relation to a diamond reinforced composite material, due to insufficiency of materials having excellent adhesion and bondability with respect to vapor-deposited diamond.

### SUMMARY OF THE INVENTION

An object of the present invention is to improve adhesion or bonding between vapor-deposited diamond and a matrix in relation to a diamond reinforced composite material.

The object is achieved with a method as defined in claim 1. Preferred embodiments are disclosed in the sub-claims.

The reinforcing material has a layer which is more strongly bonded to the matrix as compared with the diamond itself at least in a boundary portion between the same and the matrix, so that this layer further reinforces bonding between the diamond and the matrix as compared with that in the absence thereof.

According to the present invention, provided is a method of preparing a diamond reinforced composite material which comprises a step of providing vapor-deposited diamond serving as a reinforcing material, a step of removing hydrogen from the surface of the vapor-deposited diamond, and a step of mixing the vapor-deposited diamond with a matrix material for forming a composite material.

According to a further aspect of the present invention, provided is a method of preparing a diamond reinforced composite material comprising a step of preparing a reinforcing material, mainly composed of vapor-deposited diamond, having a layer which can be strongly bonded to a matrix material as compared with the diamond at least on its surface, and a step of mixing the reinforcing material with the matrix material for forming a composite material.

According to the present invention, the reinforcing material can consist essentially of at least one vapor-deposited diamond selected from the group of needle-shaped diamond, diamond fiber, diamond whisker and porous diamond, and combinations thereof.

The foregoing and other objects, features, aspects and advantages of the present invention will become more apparent from the following detailed description of the present invention when taken in conjunction with the accompanying drawings.

### BRIEF DESCRIPTION OF THE DRAWING

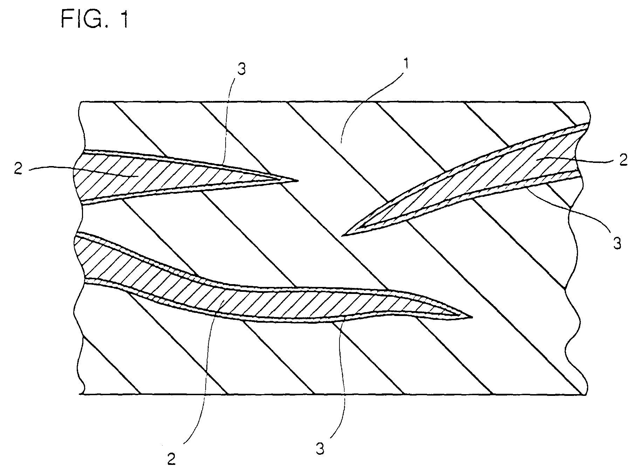

Fig. 1 is a sectional view typically showing an exemplary composite material according to the present invention. Reinforcing materials 2 consisting essentially of diamond are dispersed in a matrix 1. The reinforcing materials 2 are provided on surfaces thereof with intermediate layers 3 for improving bonding between the matrix 1 and the diamond.

### DESCRIPTION OF THE PREFERRED EMBODIMENTS

In the present invention, hydrogen is removed from the surface of vapor-deposited diamond serving as a reinforcing material. The inventors have investigated the cause for insufficiency in bonding strength between vapor-deposited diamond and a matrix, to find that hydrogen which is bonded to the surface of the diamond during the vapor deposition process inhibits bonding between the matrix and the diamond. When the matrix is prepared from a metal, for example, a fragile metal hydrogen compound is formed by such hydrogen on an interface between the matrix and the diamond. This compound depresses bonding between the diamond and the metal. When the reinforcing material is prepared from vapor-deposited diamond, therefore, it is important to remove hydrogen which is bonded to its surface. Also when the matrix is prepared from resin, removal of hydrogen brings stronger bonding between the diamond and the resin. According to the present invention, the amount of hydrogen atoms which are bonded onto the diamond surface is reduced to not more than about 1 x 10¹⁵/cm². In practice, the amount of hydrogen atoms which are present on a diamond surface is about 1.5 x 10¹³/cm² to about 1 x 10¹⁵/cm², preferably about 1.5 x 10¹³/cm² to about 2 x 10¹⁴/cm², for example. Particularly when the matrix is prepared from a metal or an organic polymer, the surface of vapor-deposited diamond containing not more than about 1 x 10¹⁵/cm² of hydrogen atoms is bonded to the matrix with sufficient strength, to provide a diamond reinforced composite material.

According to the present invention, the step of removing hydrogen from the surface of vapor-deposited diamond may include a step of heat treating the diamond under an oxidative atmosphere at a temperature of about 150°C to about 800°C. The oxidative atmosphere can be prepared from air or an atmosphere containing oxygen in an amount identical to or exceeding that of air. Under such an oxidative atmosphere, it is impossible to sufficiently effectively remove hydrogen which is bonded to carbon atoms forming the vapor-deposited diamond at a temperature of less than 150°C. When the temperature exceeds 800°C, on the other hand, the diamond may be strongly corroded under the oxidative atmosphere. In another mode of the present invention, it is possible to heat vapor-deposited diamond under a non-oxidative atmosphere at a temperature of about 800°C to about 1500°C, in order to remove hydrogen from the surface of the diamond. The non-oxidative atmosphere can be prepared from inert gas or a vacuum, for example. Under the non-oxidative atmosphere, a temperature of less than 800°C is insufficient for uncoupling hydrogen from carbon atoms. When the temperature exceeds 1500°C, on the other hand, the diamond may be corroded also under the non-oxidative atmosphere. In still another mode of the present invention, the step of removing hydrogen from the surface of vapor-deposited diamond can include a step of exposing the diamond into plasma containing oxygen. In this case, it is possible to uncouple hydrogen bonded onto the diamond surface under the room temperature.

It is possible to form a layer consisting essentially of a material other than diamond or doped diamond at least on a surface of vapor-deposited diamond for improving bonding strength between the diamond and a matrix through this layer. This intermediate layer is strongly bonded to both of the diamond and the matrix. The intermediate layer is a coating covering the surface of the diamond, and this coating consists essentially of at least one material selected from the group consisting of Aℓ, Si, B, Ti, V, Cr, Mn, Fe, Co, Ni, Zr, Nb, Mo, Hf, Ta and W, and alloys thereof, a carbide, a nitride and a boride thereof, and combinations thereof. Such a coating can be formed by CVD or PVD technique. For example, it is possible to expose diamond which is heated at a temperature of about 1000°C to about 1500°C to a gas containing Si, thereby forming an SiC layer on its surface. SiC, which can adhere to a metal such as Aℓ, resin or ceramics with sufficient strength, improves bonding between the diamond and the matrix. The intermediate layer can consist essentially of graphite. Such a graphite layer can be formed by heating the surface of the diamond, for example. Heating vapor-deposited diamond under a non-oxidative atmosphere at a temperature of about 1000°C to about 1500°C, can convert the surface of the diamond to a graphitic carbon layer. In this case, formation of the graphite is not much progressed under a temperature of less than 1000°C, while the overall diamond may disadvantageously be converted to graphite if the temperature exceeds 1500°C.

The intermediate layer or the reinforcing material itself can consist essentially of vapor-deposited diamond doped with boron (B), nitrogen (N) or a combination thereof. B and N can be doped into diamond in large amounts without damaging mechanical properties of the diamond, to improve the surface of the diamond in bonding to the matrix. B and N are suitable as impurities in points that the same can be doped in considerable amounts and that the same will not deteriorate mechanical properties of the diamond. Further, B and N can be easily introduced into the diamond as impurities in vapor deposition of the diamond. B or N doped diamond can be vapor-deposited in accordance with a conventional technique, such as that disclosed in Japanese Patent Laying-Open No. 58-135117 (1983) or 59-137396 (1984), for example. Concentration of B, N or a combination thereof which is contained in the diamond is preferably in a range of about 50 ppm to about 20000 ppm. Diamond doped with less than 50 ppm of such an impurity is insufficient in improvement in bondability to the matrix. If the impurity concentration exceeds 20000 ppm, on the other hand, the doped diamond is reduced in strength. In order to introduce a large amount of impurity into the diamond without reducing strength of the diamond itself, it is more preferable to simultaneously and homogeneously dope the diamond with B and N at a mole weight ratio of 1:1. A process of forming a diamond reinforcing material which is coated with such doped diamond can comprise steps of forming diamond by vapor deposition, and vapor-depositing a diamond layer on the diamond while doping the same with B, N or a combination thereof.

According to the present invention, the matrix can be prepared from at least one material selected from the group consisting of a metal, a semi-metal, ceramics and an organic polymer such as resin, and combinations thereof. The metal or the semi-metal for the matrix can be selected from the group consisting of Al, Mg, Ti, Si, Be, Zr, Ni, Co, Fe, Cr, and alloys thereof. Each alloy preferably contains at least 20 % of any metal. The matrix metal is mixed with diamond having a modified surface, and the mixture as formed is subjected to deformation processing such as rolling or extrusion, to form a sheet-type or linear diamond reinforced metal. In this case, the content of the diamond occupying the raw material mixture is preferably not more than about 60 percent by volume, and more preferably about 5 percent by volume to about 50 percent by volume. If a larger amount of the diamond component than 60 percent is contained in the raw material, strength of the diamond reinforced metal is reduced. On the other hand, the matrix can consist essentially of a compound which is selected from the group consisting of a carbide, a nitride, a boride and an oxide of Aℓ, Mg, Si, B, Ti, V, Zr, Nb, Mo, Hf, Ta and W, and combinations thereof. For example, ceramics used as the matrix may include Si₃N₄, SiC, zirconia, alumina, mullite or the like. Ceramics such as SiC or Si₃N₄ is mixed with the diamond having a modified surface so that the mixture as formed is then molded and sintered to provide diamond reinforced ceramics. When the matrix is prepared from an organic polymer, the diamond can be combined with thermoplastic resin or thermosetting resin. Examples of the thermoplastic resin are addition polymerization polyethylene, polypropylene, polyvinyl chloride, polystyrene, polyvinylidene chloride, fluororesin, polymethyl methacrylate, polycondensation polyamide, polyester, polycarbonate, polyphenylene oxide, polyaddition thermoplastic polyurethane and ring-opening polymerization polyacetal. The mixture of the thermoplastic resin and the diamond having a modified surface may be molded by ordinary injection molding, to a composite material. On the other hand, examples of the thermosetting resin are urea resin, melamine resin and phenol resin. When the matrix is prepared from such thermosetting resin, it is possible to prepare a composite material by mixing a liquid type matrix with diamond having a modified surface, and heating the mixture for hardening the same. Other materials such as polyimide, polyphenylene, sulfide, polyether sulfone, polyetherketone, polyimide, epoxy resin and the like may be used as the resin matrix.

When the surface of diamond is reformed in accordance with the present invention, bonding between the diamond and the matrix material is remarkably improved. This brings not only a composite material which is excellent in mechanical strength but a composite material having a large area or a long size. If vapor-deposited diamond with no modification on its surface, is mixed with a matrix the composite material as obtained has inferior strength and it is difficult to obtain a composite material having a large area or a long size. The composite material according to the present invention has excellent wear resistance, heat conductivity, heat resistance, corrosion resistance and radiation resistance, and high mechanical strength. The composite material according to the present invention can be applied to a use in a wider range and under severer conditions as compared with the prior art. For example, the composite material according to the present invention can provide a sliding material with a longer life than that of the prior art, due to excellent wear resistance. Further, the composite material according to the present invention which is resistant against radiation can be employed for forming the airframe of a space aircraft. In addition, the present invention widens the range of materials employable for a matrix by improving bondability of diamond to the matrix.

Examples of the present invention are now described in detail.

### Example 1

According to the technic disclosed by Japanese Patent Laying-Open No. 1-246116 (1989), diamond as a reinforcing material was prepared as follows.

A diamond film of about 100 µm in thickness was deposited on a silicon substrate in microwave plasma CVD. CVD conditions were as follows:
Raw Material: mixed gas of 3 % of methane and hydrogen
Pressure: 40 Torr
Substrate Temperature: 850°C

The diamond film as obtained was exposed to hydrogen plasma of 80 Torr in pressure in a plasma etching apparatus at a temperature of 980°C for about 20 minutes. The silicon substrate was dissolved with a dilute mixed solution of hydrofluoric acid and nitric acid, to separate the treated film from the substrate. As the result, the diamond film which was cracked by the plasma treatment was finely decomposed, to provide needle-shaped and fibrous diamonds (hereinafter referred to as diamond fiber) having an average length of about 100 µm and an average diameter of about 5 µm.

About 2 g of the diamond fiber as obtained was introduced into a reaction chamber, and held in the air at 500°C for about 1 hour. Thus, hydrogen was removed from the surface of the diamond. Since it was difficult to directly measure an amount of hydrogen on the surface of the diamond fiber, the following experiment was carried out. The diamond film on a single-crystal diamond substrate as obtained under the above conditions was introduced into the reaction chamber, and held in the air at 500°C for about 1 hour. An amount of hydrogen atoms on the diamond film surface was then measured by the elastic recoil detection (ERD), and the value of 9.6 x 10¹³/cm² was obtained as the amount of hydrogen atoms. This result suggested about 9.6 x 10¹³/cm² of hydrogen atoms on the surface of the diamond fiber. 2 g of the diamond fiber whose surface was reformed in the aforementioned manner was mixed with 20 g of a commercially available polyethylene pellet, and the mixture was heated in the atmosphere to 400°C and injection-molded, to prepare diamond reinforced polyethylene resin. A sample A was prepared from the diamond reinforced resin as obtained, and subjected to measurement of the modulus of elasticity and tensile strength. Table 1 shows the results.

### Example 2

About 2 g of the diamond fiber obtained in Example 1 was introduced into a reaction chamber, and held in a vacuum of 10⁻⁴ Torr at 1200°C for 1 hour. The analysis by the surface sensitization Raman spectroscopy resulted in 0.91 value as a peak ratio (Y/X) of the graphite carbon peak value (Y) to the diamond carbon peak value (X). As a result, it was confirmed that graphite was formed on the diamond surface. 2 g of the diamond fiber whose surface was reformed in the aforementioned manner was mixed with 20 g of a commercially available polyethylene pellet, and the mixture was heated in the atmosphere to 400°C and injection-molded, to prepare diamond reinforced polyethylene resin. A sample B was prepared from the composite material as obtained, and subjected to measurement of the modulus of elasticity and tensile strength. Table 1 shows the results.

### Example 3

About 2 g of the diamond fiber obtained in Example 1 was introduced into a reaction chamber, and exposed to a water steam atmosphere of 0.2 Torr, to which a high-frequency discharge of 80 W was applied, under the room temperature for 10 minutes. Thus, hydrogen was removed from the surface of the diamond. 2 g of the diamond fiber whose surface was reformed in the aforementioned manner was mixed with 20 g of a commercially available polyethylene pellet, and the mixture was heated in the atmosphere to 400°C and injection-molded, to prepare diamond reinforced polyethylene resin. A sample C was prepared from the composite material as obtained, and subjected to measurement of the modulus of elasticity and tensile strength. Table 1 shows the results.

### Comparative Example 1

About 2 g of the diamond fiber obtained in Example 1 was introduced into a reaction chamber, and exposed to a hydrogen atmosphere of 5 Torr, to which a microwave discharge of 150 W was applied, under the room temperature for about 30 minutes. On the other hand, the diamond film on the single-crystal diamond substrate as obtained in Example 1 was introduced into the reaction chamber, and exposed to a hydrogen atmosphere of 5 Torr, to which a microwave discharge of 150W was applied under the room temperature for about 30 minutes. An amount of hydrogen atoms on the diamond film surface was then measured by ERD, and the value of 2.4 x 10¹⁵/cm² was obtained. This result suggested at least 2.4 x 10¹⁵/cm² of hydrogen atoms on the surface of the diamond fiber. 2 g of the diamond fiber as treated was mixed with 20 g of a commercially available polyethylene pellet, and the mixture was heated in the atmosphere to 400°C and injection-molded, to prepare diamond reinforced polyethylene resin. A sample E was prepared from the composite material as obtained, and subjected to measurement of the modulus of elasticity and tensile strength. Table 1 shows the results.

### Comparative Example 2

The diamond fiber obtained in Example 1 was employed for forming a composite material as such with no treatment on its surface. 2 g of the diamond fiber was mixed with 20 g of a commercially available polyethylene pellet, and the mixture was heated in the atmosphere to 400°C and injection-molded, to prepare diamond reinforced polyethylene resin. A sample F was prepared from the composite material as obtained, and subjected to measurement of the modulus of elasticity and tensile strength. Table 1 shows the results.

**Table 1**

| Sample | Modulus of Elasticity (GPa) | Tensile Strength (MPa) |
|---|---|---|
| A | 105 | 360 |
| B | 125 | 420 |
| C | 110 | 450 |
| D | 120 | 510 |
| E | 90 | 80 |
| F | 94 | 150 |

From the results shown in Table 1, it was confirmed that each diamond reinforced polyethylene resin according to the present invention was improved in both of the modulus of elasticity and tensile strength as compared with each comparative example.

### Comparative Example 3

3 g of the diamond fiber obtained in Example 5 was mixed as such with 30 g of Al powder in which 8 percent by weight of Si was solidly dissolved, and the mixture as such was sintered at 400°C, to prepare a diamond reinforced aluminum alloy. A sample I was prepared from the composite material as obtained, and subjected to measurement of the modulus of elasticity and tensile strength. Table 2 shows the results.

### Comparative Example 4

The diamond fiber with no surface treatment was applied to a composite material. 5 g of the diamond fiber was mixed with 25 g of Si₃N₄ powder and 1 g of Y₂O₃ powder, and the mixture as obtained was sintered at 1350°C, to prepare diamond reinforced silicon nitride ceramics. A sample L was prepared from the composite material as obtained, and subjected to measurement of the modulus of elasticity and bending strength. Table 3 shows the results.

**Table 3**

| Sample | Modulus of Elasticity (GPa) | Bending Strength (MPa) |
|---|---|---|
| K | 480 | 410 |
| L | 460 | 360 |

From the results shown in Table 3, it was confirmed that the diamond reinforced polyethylene resin according to the present invention was improved in both of the modulus of elasticity and bending strength as compared with comparative example.

Although the present invention has been described and illustrated in detail, it is clearly understood that the same is by way of illustration and example only and is not to be taken by way of limitation, the scope of the present invention being limited only by the terms of the appended claims.

## Claims

1. A method of preparing a diamond reinforced composite material, comprising:
a step of providing vapor-deposited diamond serving as a reinforcing material;
a step of removing hydrogen from the surface of said vapor-deposited diamond; and
a step of mixing said vapor-deposited diamond with said matrix thereby forming a composite material;
wherein the diamond reinforced composite material comprises:
a matrix; and
a reinforcing material, consisting essentially of vapor-deposited diamond, being dispersed in said matrix,
the amount of hydrogen atoms being present in a portion of said vapor-deposited diamond corresponding to an interface between the same and that matrix being not more than about 1 x 10¹⁵ /cm².

2. A method of preparing a diamond reinforced composite material in accordance with claim 1, wherein
said step of removing hydrogen comprises a step of heating said vapor-deposited diamond under an oxidative atmosphere at a temperature of about 150°C to about 800°C.

3. A method of preparing a diamond reinforced composite material in accordance with claim 1, wherein
said step of removing hydrogen comprises a step of heating said vapor-deposited diamond under a non-oxidative atmosphere at a temperature of about 800°C to about 1500°C.

4. A method of preparing a diamond reinforced composite material in accordance with claim 1, wherein
said step of removing hydrogen comprises a step of exposing said vapor-deposited diamond into plasma containing oxygen.

5. The method of preparing a diamond reinforced composite material in accordance with any of claims 1-4, wherein said reinforcing material consists essentially of vapor-deposited diamond selected from the group consisting needle-shaped diamond, diamond fiber, diamond whisker and porous diamond, and combinations thereof.

6. The method of preparing a diamond reinforced composite material in accordance with any of claims 1-4, wherein said matrix consists essentially of at least one material being selected from a metal, semi-metal, ceramics, an organic polymer and combinations thereof.

7. The method of preparing a diamond reinforced composite material in accordance with any of claims 1-4, wherein said matrix consists essentially of at least one material selected from the group consisting of Al, Mg, Ti, Si, Be, Zr, Ni, Co, Fe, Cr, and alloys thereof.

8. The method of preparing a diamond reinforced composite material in accordance with any of claims 1-4, wherein said matrix consists essentially of at least one compound elected from the group consisting of a carbide, a nitride, a boride and an oxide of Al, Mg, Si, B, Ti, V, Zr, Nb,Mo, Hf, Ta and W and combinations thereof.

## Patentansprüche

1. Verfahren zur Herstellung eines diamantverstärkten Verbundmaterials, umfassend:
einen Schritt des Anordnens von aufgedampftem Diamant, der als ein verstärkendes Material dient;
einen Schritt des Entfernens von Wasserstoff aus der Oberfläche des aufgedampften Diamanten; und
ein Schritt des Vermischens des aufgedampften Diamanten mit der Matrix, um dadurch ein Verbundmaterial zu bilden;
worin das diamantverstärkte Verbundmaterial umfaßt:
eine Matrix; und
ein verstärktes Material, das im wesentlichen aus aufgedampftem Diamant besteht, der in der Matrix verteilt ist,
wobei der Betrag an Wasserstoffatomen in einem Teil des aufgedampften Diamanten, der mit einer Schnittstelle zwischen demselben und der Matrix korrespondiert, vorhanden ist, wobei dieser nicht mehr als ungefähr als 1 x 10¹⁵/cm² ist.

2. Verfahren zur Herstellung eines diamantverstärkten Verbundmaterials nach Anspruch 1, worin
der Schritt des Entfernens von Wasserstoff einen Schritt des Erwärmens des aufgedampften Diamanten in einer oxidativen Atmosphäre auf einer Temperatur von ungefähr 150°C bis ungefähr 800°C umfaßt.

3. Verfahren zur Herstellung eines diamantverstärkten Verbundmaterials nach Anspruch 1, worin
der Schritt des Entfernens von Wasserstoff einen Schritt des Erwärmens des aufgedampften Diamanten in einer nicht-oxidativen Atmosphäre bei einer Temperatur von ungefähr 800°C bis ungefähr 1500°C umfaßt.

4. Verfahren zur Herstellung eines diamantverstärkten Verbundmaterials nach Anspruch 1, worin
der Schritt des Entfernens von Wasserstoff einen Schritt des Aussetzens des aufgedampften Diamanten einem Plasma, das Sauerstoff enthält, umfaßt.

5. Verfahren zur Herstellung eines diamantverstärkten Verbundmaterials nach einem der Ansprüche 1- 4, worin
das verstärkte Material im wesentlichen aus aufgedampftem Diamant besteht, der aus der Gruppe, die aus nadelförmigen Diamant, Diamantfasern, Diamant-Whiskerkristallen und porösem Diamant und Verbindungen davon besteht, ausgewählt wird.

6. Verfahren zur Herstellung eines diamantverstärkten Verbundmaterials nach einem der Ansprüche 1- 4, worin
die Matrix im wesentlichen aus mindestens einem Material besteht, das aus einem Metall, Halbmetall, Keramik, einem organischen Polymer oder einer Verbindung davon ausgewählt wird.

7. Verfahren zur Herstellung eines diamantverstärkten Verbundmaterials nach einem der Ansprüche 1- 4, worin
die Matrix im wesentlichen aus mindestens einem Material besteht, das aus der Gruppe ausgewählt wird, die aus Al, Mg, Ti, Si, Be, Zr, Ni, Co, Fe, Cr und Legierungen davon besteht.

8. Verfahren zur Herstellung eines diamantverstärkten Verbundmaterials nach einem der Ansprüche 1- 4, worin
die Matrix im wesentlichen aus mindestens einer Verbindung besteht, die aus der Gruppe ausgewählt wird, welche aus einem Carbid, einem Nitrid, einem Borid und einem Oxid von Al, Mg, Si, B, Ti, V, Zr, Nb, Mo, Hf, Ta und W Verbindungen davon besteht.

## Revendications

1. Procédé de préparation d'un matériau composite renforcé par du diamant, comprenant :
une étape consistant à fournir un diamant déposé en phase vapeur servant de matière renforçante ;
une étape consistant à enlever l'hydrogène de la surface dudit diamant déposé en phase vapeur ; et
une étape consistant à mélanger ledit diamant déposé en phase vapeur avec ladite matrice, formant ainsi un matériau composite ;
dans lequel le matériau composite renforcé par du diamant comprend :
une matrice ; et
un matériau renforçant, essentiellement constitué par du diamant déposé en phase vapeur, dispersé dans ladite matrice,
la quantité d'atomes d'hydrogène présents dans une partie dudit diamant déposé en phase vapeur correspondant à une interface entre celui-ci et la matrice n'étant pas supérieure à environ 1 x 10¹⁵/ cm².

2. Procédé de préparation d'un matériau composite renforcé par du diamant selon la revendication 1, dans lequel
ladite étape d'enlèvement de l'hydrogène comprend une étape consistant à chauffer ledit diamant déposé en phase vapeur sous une atmosphère oxydante à une température d'environ 150 °C à environ 800 °C.

3. Procédé de préparation d'un matériau composite renforcé par du diamant selon la revendication 1, dans lequel
ladite étape d'enlèvement d'hydrogène comprend une étape consistant à chauffer ledit diamant déposé en phase vapeur sous une atmosphère oxydante à une température d'environ 800 °C à environ 1500 °C.

4. Procédé de préparation d'un matériau composite renforcé par du diamant selon la revendication 1, dans lequel ladite étape d'enlèvement d'hydrogène comprend une étape consistant à exposer ledit diamant déposé en phase vapeur dans un plasma contenant de l'oxygène.

5. Procédé de préparation d'un matériau composite renforcé par du diamant selon la revendication 4, dans lequel ledit matériau renforçant est essentiellement constitué par un diamant déposé en phase vapeur choisi dans le groupe constitué par le diamant en forme d'aiguille, la fibre de diamant, la trichite de diamant et le diamant poreux, et les combinaisons de ceux-ci.

6. Procédé de préparation d'un matériau composite renforcé par du diamant selon la revendication 4, dans lequel ladite matrice est essentiellement constituée par au moins un matériau choisi parmi un métal, un semi-métal, une céramique, un polymère organique et les combinaisons de ceux-ci.

7. Procédé de préparation d'un matériau composite renforcé par du diamant selon la revendication 4, dans lequel ladite matrice est essentiellement constituée par au moins un matériau choisi dans le groupe constitué par Al, Mg, Ti, Si, Be, Zr, Ni, Co, Fe, Cr et les alliages de ceux-ci.

8. Procédé de préparation d'un matériau composite renforcé par du diamant selon la revendication 4, dans lequel ladite matrice est essentiellement constituée par au moins un composé choisi dans le groupe constitué par un carbure, un nitrure, un borure et un oxyde de Al, Mg, Si, B, Ti, V, Zr, Nb, Mo, Hf, Ta et W et les combinaisons de ceux-ci.
